# EUROPÄISCHE PATENTANMELDUNG

(11) **EP 1 887 675 A2**
(43) Veröffentlichungstag der Anmeldung: **13.02.2008**
(21) Anmeldenummer: 07111774.1
(22) Anmeldetag: 05.07.2007
(51) Int. Cl.: H02J 3/38, H02M 7/48

(54) **Photovoltaikanlage mit Isolationswiderstandsmessung von Solargeneratoren und Verfahren zum Betreiben derselben**

(30) Priorität: 08.08.2006 DE 102006037043
(71) Anmelder: Siemens Aktiengesellschaft Österreich, 1210 Wien (AT)
(72) Erfinder: Reithmayer, Franz, 1110, Wien (AT); Reschenauer, Stefan, 2244, Spannberg (AT)
(74) Vertreter: Peham, Alois

(57) **Zusammenfassung**

Die Erfindung betrifft eine Photovoltaikanlage mit wenigstens zwei Wechselrichtern (3), welche über Wechselstromleitungen mittels einer gemeinsamen selbsttätigen Netz-Freischalteinrichtung (1) an ein Stromnetz angeschaltet sind und wobei die selbsttätige Netz-Freischalteinrichtung (1) eine Messschaltung (2) zur Messung der Isolationswiderstände von an die Wechselrichter (3) angeschlossenen Solargeneratoren (5) gegenüber Erde umfasst, wobei des Weiteren jeder Wechselrichter (3) Bypassleitungen zur Überbrückung der Leistungsteile (4) umfasst und in den Bypassleitungen hochohmige Widerstände (R3, R4) angeordnet sind. Diese Bypassleitungen wirken dabei als passive Elemente der Messschaltung zur Messung der Isolationswiderstände (R_{DC+}, R_{DC-}) der an die Wechselrichter (3) angeschlossenen Solargeneratoren (5).

## Beschreibung

Die Erfindung betrifft eine Photovoltaikanlage mit wenigstens zwei Wechselrichtern, welche über Wechselstromleitungen mittels einer gemeinsamen selbsttätigen Netz-Freischalteinrichtung an ein Stromnetz angeschaltet sind und wobei die selbsttätige Netz-Freischalteinrichtung eine Messschaltung zur Messung der Isolationswiderstände von an die Wechselrichter angeschlossenen Solargeneratoren gegenüber Erde umfasst. Des Weiteren betrifft die Erfindung ein Verfahren zum Betreiben der Photovoltaikanlage.

Die Stromerzeugung mittels Photovoltaikanlagen, wobei der erzeugte Strom in ein öffentliches Netz eingespeist wird, gewinnt zunehmend an Bedeutung. Derartige Anlagen bestehen aus mehreren Solargeneratoren bzw. Solarpanelen, Wechselrichtern zur Umwandlung des erzeugten Gleichstromes in einen Wechselstrom und diversen Steuerungs- und Sicherheitseinrichtungen.

Bei größeren Anlagen kommen in der Regel mehrere Wechselrichter zum Einsatz, die wechselstromseitig parallel geschaltet sind und über eine gemeinsame so genannte selbsttätige Netz-Freischalteinrichtung, wie sie seit 1999 durch die Norm E DIN VDE 0126 als ENS beschrieben ist, mit einem öffentlichen Stromnetz verbunden sind (Gabler Hansjörg: Photovoltaische Großanlagen - Technologie und Realisierung, FVS Themen 2002, Forschungsverbund Sonnenenergie). Steuerungstechnisch ist dabei zumeist ein Wechselrichter als Master definiert, wobei diesem die selbsttätige Netz-Freischalteinrichtung zugeordnet ist. Die weiteren Wechselrichter speisen den erzeugten Strom als Slaves parallel zum Master über die selbsttätige Netz-Freischalteinrichtung ins Stromnetz ein.

Vor der Anschaltung einer Photovoltaikanlage ist in Deutschland, Österreich und einigen anderen Ländern eine Isolationsprüfung der Solargeneratoren gegenüber Erde gefordert. Die entsprechende Messanordnung ist in der Regel Teil der selbsttätigen Netz-Freischalteinrichtung. Da diese selbsttätige Netz-Freischalteinrichtung bei einem Master-Slave-Konzept nur dem Master zugeordnet ist, sind nach dem Stand der Technik zur Isolationsmessung der mit den Slaves verbundenen Solargeneratoren zumeist eigene Verbindungsleitungen zwischen Master mit der selbsttätigen Netz-Freischalteinrichtung und den Slaves vorgesehen.

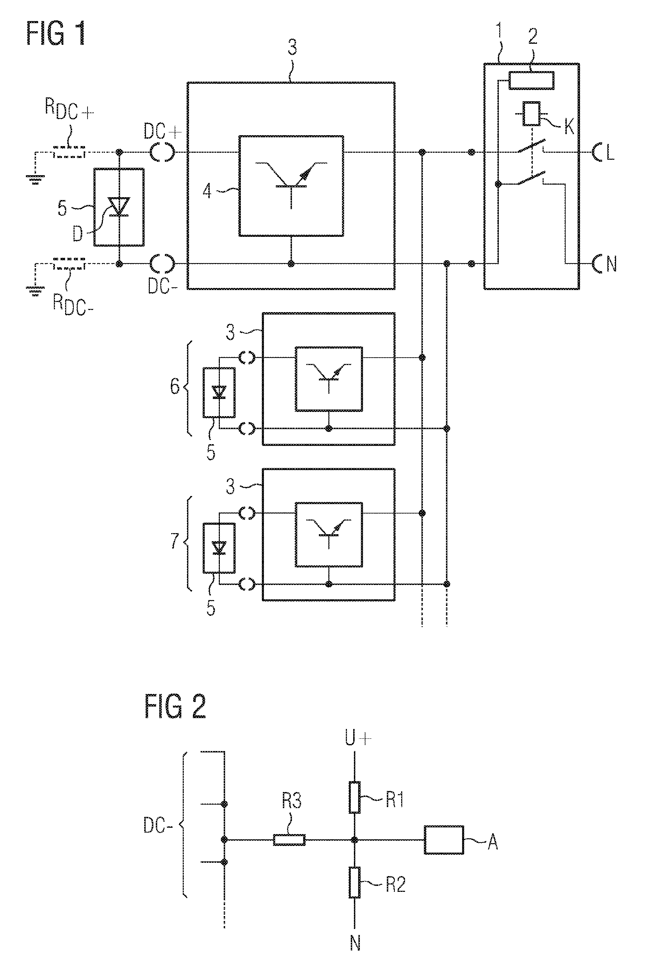

Bei Wechselrichtern mit durchgängigem Nulleiter kennt man auch Messanordnungen, die den Isolationswiderstand der Solargeneratoren gegenüber Erde bei abgeschalteten Leistungsteilen über den Nulleiter messen (siehe Fig. 1 und Fig. 2). Der Nulleiter verbindet dabei die Messanordnung in der selbsttätigen Netz-Freischalteinrichtung direkt mit jedem Solargenerator, unabhängig davon, ob dieser über den Master oder über einen Slave angebunden ist.

Zur Isolationsmessung wird an den Nullleiter eine positive Messspannung angelegt, wobei die Solargeneratoren in Sperrrichtung betrieben werden. Das führt jedoch zu dem Nachteil, dass bei hochwertigen Solargeneratoren nur für negative Pole unzulässig niedrige Isolationswiderstände gegenüber Erde sicher erkannt werden können. Ein zu niedriger Isolationswiderstand eines positiven Pols gegenüber Erde wird hingegen nicht sicher erkannt, wenn der Leckstrom in Sperrrichtung eines als Diode wirkenden Solargenerators zu gering ist, um von einer Auswerteeinrichtung in der selbsttätige Netz-Freischalteinrichtung erkannt zu werden.

Der Erfindung liegt die Aufgabe zugrunde, für eine Photovoltaikanlage der eingangs genannten Art eine Verbesserung gegenüber dem Stand der Technik anzugeben.

Erfindungsgemäß wird diese Aufgabe gelöst durch eine Photovoltaikanlage mit wenigstens zwei Wechselrichtern, welche über Stromleitungen mittels einer gemeinsamen selbsttätigen Netz-Freischalteinrichtung an ein Stromnetz angeschaltet sind und wobei die selbsttätige Netz-Freischalteinrichtung eine Messschaltung zur Messung der Isolationswiderstände von an die Wechselrichter angeschlossenen Solargeneratoren gegenüber Erde umfasst und zudem jeder Wechselrichter Bypassleitungen zur Überbrückung der Leistungsteile umfasst und in den Bypassleitungen hochohmige Widerstände angeordnet sind.

Diese Bypassleitungen wirken dabei als passive Elemente der Messschaltung zur Messung der Isolationswiderstände der an die Wechselrichter angeschlossenen Solargeneratoren. Mittels einer Auswerteeinrichtung in der selbsttätigen Netz-Freischalteinrichtung sind die Isolationswiderstände sowohl des negative Pol als auch des positiven Pols aller Solargeneratoren messbar, noch bevor die Wechselrichter mit Strom versorgt werden. Diese Lösung ist für Wechselrichter mit durchverbundenem Nullleiter und solche mit nicht durchverbundenem Nullleiter anwendbar, wobei als Messleitungen zwischen den Solargeneratoren und der Auswerteeinrichtung nur die zur Leistungsübertragung vorgesehenen Leitungen genutzt werden. Es sind also keine zusätzlichen Leitungen zwischen der selbsttätigen Netz-Freischalteinrichtung und den einzelnen Wechselrichtern bzw. zwischen den Wechselrichtern und den Solargeneratoren erforderlich, um die Isolationswiderstände beider Pole aller Solargeneratoren der Anlage zentral zu messen.

Dabei ist es vorteilhaft, wenn bei Wechselrichtern mit durchverbundenem Nullleiter jeder Wechselrichter in der Weise ausgebildet ist, dass eine erste Bypassleitung zwischen dem positiven Pol auf der Gleichstromseite und dem Leiter auf der Wechselstromseite angeordnet ist und wenn eine zweite Bypassleitung zwischen dem Leiter und dem Nulleiter auf der Wechselstromseite angeordnet ist. Damit ist für die zentrale Isolationswiderstandsmessung eine einfache Schaltung mit geringem Fertigungsaufwand für jeden Wechselrichter angegeben.

Für Wechselrichter ohne durchverbundenem Nullleiter ist es vorteilhaft, wenn eine erste Bypassleitung zwischen dem positiven Pol auf der Gleichstromseite und dem Leiter auf der Wechselstromseite angeordnet ist und wenn eine zweite Bypassleitung zwischen dem negativen Pol auf der Gleichstromseite und dem Leiter auf der Wechselstromseite angeordnet ist. Die beiden Bypassleitungen überbrücken den Leistungsteil jedes Wechselrichters in einfacher Weise und ermöglichen so die zentrale Isolationswiderstandsmessung aller Solargeneratoren.

Die Anordnung der Bypassleitungen mit hochohmigen Widerständen erfordert nur einen geringen Aufwand im Gegensatz zu zusätzlicher Messleitungen, welche ansonsten zwischen den Wechselrichtern und einer zentralen Auswerteeinrichtung in der selbsttätigen Netz-Freischalteinrichtung verlegt werden müssten. Die Funktionsweise der Wechselrichter im Betrieb wird durch die Bypassleitungen aufgrund der hohen Widerstandswerte nicht beeinflusst.

Betrieben wird eine erfindungsgemäße Photovoltaikanlage in der Weise, dass vor jeder Anschaltung an das Stromnetz mittels selbsttätiger Netz-Freischalteinrichtung die Messung der Isolationswiderstände beider Pole der Solargeneratoren gegenüber Erde bei abgeschalteten Leistungsteilen der Wechselrichter erfolgt. Damit wird zunächst nur die selbsttätige Netz-Freischalteinrichtung mit der Auswerteeinrichtung aus dem angeschlossenen Wechselstromnetz versorgt. Die in der selbsttätigen Netz-Freischalteinrichtung angeordneten Schaltorgane zum Anschalten der Wechselrichter an das Wechselstromnetz bleiben während der Messdurchführung ausgeschaltet. Die Anschaltung der Wechselrichter und damit die Aktivierung der Wechselrichter-Leistungsteile erfolgt erst, nachdem mittels Auswerteeinrichtung ausreichend hohe Isolationswiderstände aller Solargeneratoren gegenüber Erde festgestellt wurden.

Andererseits werden unzulässig niedrige Isolationswiderstände noch vor Aktivierung der Wechselrichter erkannt. Bis auf die Auswerteeinrichtung bleibt die gesamte Photovoltaikanlage im Fehlerfall abgeschaltet.

Dabei ist es von Vorteil, wenn die Messung der Isolationswiderstände beider Pole der Solargeneratoren gegenüber Erde in der Weise erfolgt, dass die Wechselstromleitungen zwischen den Wechselrichtern und der selbsttätiger Netz-Freischalteinrichtung mit einer Messspannung beaufschlagt werden und dass ein in den Wechselstromleitungen gemessener Strom- oder Spannungswert in einer Auswerteeinrichtung ausgewertet wird. Damit ist mit geringem Aufwand eine zuverlässige Messung der Isolationswiderstände realisierbar.

Die Erfindung wird nachfolgend in beispielhafter Weise unter Bezugnahme auf die beigefügten Figuren erläutert. Es zeigen in schematischer Darstellung:
- Fig. 1: Photovoltaikanlage nach dem Stand der Technik
- Fig. 2: Messschaltung nach dem Stand der Technik
- Fig. 3: erfindungsgemäße Photovoltaikanlage mit durchverbundenem Nullleiter
- Fig. 4: erfindungsgemäße Messschaltung
- Fig. 5: erfindungsgemäße Photovoltaikanlage ohne durchverbundenem Nullleiter

Die in Figur 1 dargestellte Photovoltaikanlage mit durchverbundenem Nullleiter nach dem Stand der Technik umfasst einen ersten Wechselrichter 3 mit einem daran angeschlossenen Solargenerator 5 sowie zwei weitere Leistungsstränge 6 und 7 mit einem Wechselrichter und daran angeschlossenem Solargenerator, wobei jeder Wechselrichter über eine zweiphasige Wechselspannungsleitung mit einer selbsttätigen Netz-Freischalteinrichtung 1 verbunden ist.

Der dargestellte Schaltungsaufbau ist zur besseren Übersichtlichkeit einfach gehalten. In der Regel sind mehrere Solargeneratoren mit einem Wechselrichter verbunden. Zudem können noch weitere Leistungsstränge über die selbsttätige Netz-Freischalteinrichtung 1 an das Stromnetz angeschaltet sein. Der erste Wechselrichter 3 ist beispielsweise als Master definiert und die übrigen Wechselrichter werden als Slaves über diesen Master gesteuert. Dabei ist in der Regel jeder Wechselrichter baugleich ausgeführt und verfügt über eine eigene selbsttätige Netz-Freischalteinrichtung 1. In einem Master-Slave-Konzept ist jedoch nur die selbsttätige Netz-Freischalteinrichtung 1 des Masters aktiviert und die Slaves speisen über diese selbsttätige Netz-Freischalteinrichtung 1 in das Stromnetz ein.

In der selbsttätigen Netz-Freischalteinrichtung ist ein Relais K angeordnet, mittels welchem jede Phase vom Wechselstromnetz trennbar ist. Bei einer Anschaltung an ein Drehstromnetz sind über eine dafür vorgesehene selbsttätige Netz-Freischalteinrichtung alle drei Leiter und der Nullleiter mittels Relais vom Netz trennbar.

Die Messung der Isolationswiderstände der Solargeneratoren gegenüber Erde geschieht mittels einer Messschaltung 2, welche in der selbsttätigen Netz-Freischalteinrichtung 1 angeordnet ist. Diese ist mittels Nullleiter N über die Wechselrichter 3 zu allen Solargeneratoren 5 durchverbunden.

Der Aufbau der Messschaltung ist in Figur 2 dargestellt. Dabei wird jeder Solargenerator 5 als Diode D in Sperrrichtung betrieben. Der Leistungsteil 4 des ersten Wechselrichters 3 ist ebenso wie die Leistungsteile der übrigen Wechselrichter abgeschaltet. In der Messschaltung sind hochohmige Widerstände R1, R2 und R3 (z.B. jeweils 1 MOhm) als Spannungsteiler an eine positive Messspannung U+ angeschaltet. Bei einem fehlerhaften Isolationswiderstand des negativen Pols R_{DC}- eines Solargenerators beeinflusst der Spannungsteiler die an der Auswertungseinrichtung A anliegende Spannung und die selbsttätige Netz-Freischalteinrichtung 1 schaltet nicht ans Stromnetz.

Bei einer Anschaltung an ein Drehstromnetz funktioniert die Isolationswiderstandsmessung der Solargeneratoren 5 gegenüber Erde in gleicher Weise, wobei jeder Leiter des Drehstromnetzes mit einem oder mehreren Wechselrichtern verbunden ist.

Nachteilig ist bei dieser Messung nach dem Stand der Technik, dass ein fehlerhafter Isolationswiderstand des positiven Pols R_{DC+} eines Solargenerators 5 mitunter nicht erkannt wird. Diese Gefahr besteht vor allem bei an sich gewünschten hochwertigen Solargeneratoren, welche nur einen geringen Leckstrom in Sperrrichtung aufweisen. Die an der Auswertungseinrichtung A anliegenden Spannung bleibt unverändert und ein Isolationsfehler unbemerkt.

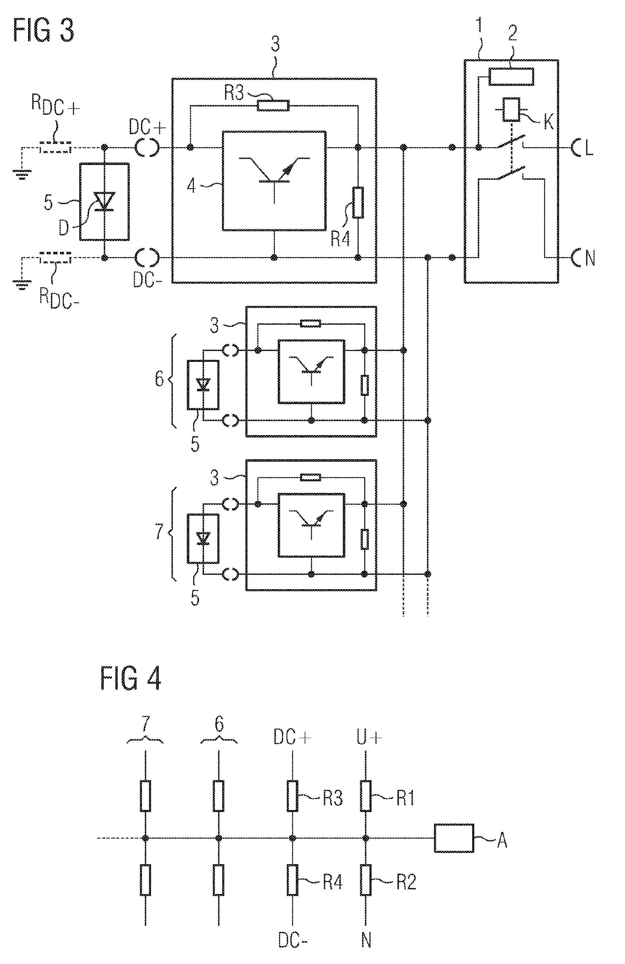

Eine beispielhafte Photovoltaikanlage nach der Lehre der vorliegenden Erfindung, welche dieses Problem löst, ist in Figur 3 dargestellt. Die Anzahl der an einen Wechselrichter 3 angeschlossenen Solargeneratoren 5 ist dabei ebenso beliebig wie die an eine selbsttätige Netz-Freischalteinrichtung 1 angeschalteten Leistungsstränge.

Gegenüber der in Figur 1 dargestellten Photovoltaikanlage sind hier in jedem Wechselrichter 3 zwei Bypassleitungen dargestellt, die den Leistungsteil 4 überbrücken. Dabei ist in jeder Bypassleitung ein hochohmiger Widerstand R3 bzw. R4 (z.B. je 1 MOhm) angeordnet, die als Teil der Messschaltung zur Bestimmung der Isolationswiderstände wirken. Der Nullleiter N ist wieder durchverbunden. Die erste Bypassleitung verbindet den positiven Pol DC+ auf der Gleichstromseite eines Wechselrichters 3 mit dem Leiter L auf der Wechselstromseite eines Wechselrichters 3. Die zweite Bypassleitung verbindet den Leiter L mit dem Nullleiter N auf der Wechselstromseite eines Wechselrichters 3.

Der in der selbsttätigen Netz-Freischalteinrichtung 1 verbliebene Teil der Messschaltung 2 ist an den gemeinsamen Leiter L angeschaltet. Die Messung erfolgt bei geöffnetem Relais K und hochohmigen Leistungsteilen 4, damit diese die Messung nicht beeinflussen. Der Leiter L liefert den Spannungswert an die Auswertungseinrichtung A. Sobald die Potenziale am positiven Pol DC+ und am negativen Pol DC- eine niederohmige elektrische Verbindung gegen Erde oder einen Erdschluss aufweisen, beeinflusst der Spannungsteiler über den Leiter L die Auswertung und die Auswertungseinrichtung A signalisiert einen Isolationsfehler. Die Auswertung erfolgt beispielsweise durch die Erfassung eines Strom- oder Spannungswertes innerhalb der Messschaltung und durch einen Vergleich mit Referenzwerten. Das Relais K zieht im Fehlerfall nicht an und die Photovoltaikanlage bleibt vom Stromnetz getrennt.

Die entsprechende Messschaltung ist in Figur 4 dargestellt. Es liegt wieder eine positive Messspannung U+ an (z.B. 5V). Die dargestellten Widerstände haben beispielhaft alle den gleichen hohen Wert (z.B. 2 MOhm). Zwischen Messspannung U+ und der Auswerteeinrichtung A ist ein erster Widerstand R1 angeordnet. Über einen zweiten Widerstand R2 liegt die Auswerteeinrichtung A am Nullleiter N an. Dieser Teil der Messschaltung ist dabei innerhalb der selbsttätigen Netz-Freischalteinrichtung 1 angeordnet. Über den Leiter L ist jeder Wechselrichter 3 mit der Auswerteeinrichtung A verbunden. Die Bypassleitungen in den Wechselrichtern 3 verbinden dabei jeden positiven Pol DC+ der angeschlossenen Solargeneratoren 5 über einen dritten Widerstand R3 und jeden negativen Pol DC- der angeschlossenen Solargeneratoren 5 über einen vierten Widerstand R4 direkt mit der Auswerteeinrichtung A.

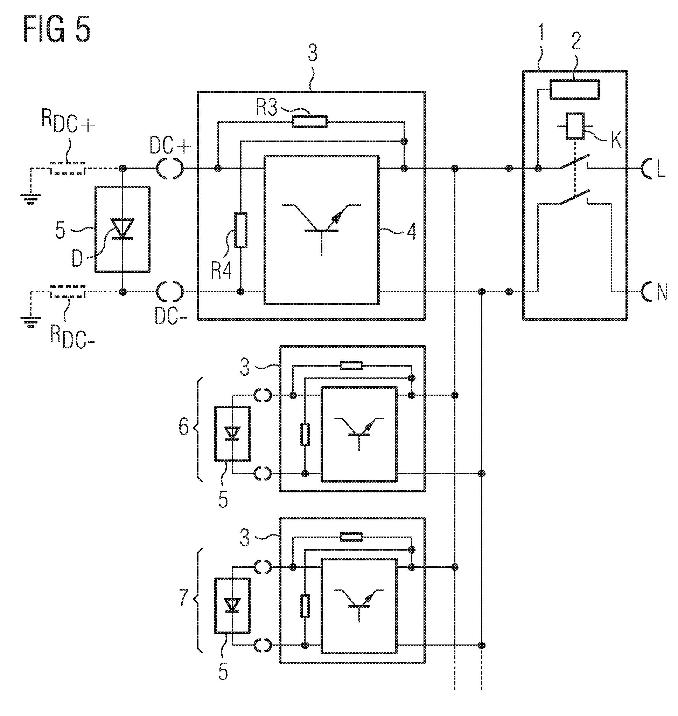

In Figur 5 ist eine beispielhafte Photovoltaikanlage mit Wechselrichtern ohne durchverbundem Nullleiter dargestellt. Die Anordnung entspricht im Wesentlichen der in Figur 3 dargestellten Photovoltaikanlage. Ein Unterschied liegt in der Überbrückung der Leistungsteile 4 der Wechselrichter 3. Jeder Wechselrichter 3 umfasst eine erste Bypassleitung mit einem hochohmigen Widerstand R3 zwischen Leiter L auf der Wechselstromseite und positiven Pol DC+ auf der Gleichstromseite und eine zweite Bypassleitung mit einem hochohmigen Widerstand R4 zwischen dem Leiter L auf der Wechselstromseite und dem negativen Pol DC- auf der Gleichstromseite. Die Messschaltung entspricht dann wieder der in Figur 3. dargestellten.

Die Messung kann auch durch andere Schaltungstopologien ausgeführt sein. So kann beispielsweise die Messschaltung in der selbsttätigen Netz-Freischalteinrichtung an den gemeinsamen Nullleiter N angeschlossen sein. In jedem Wechselrichter mit durchverbundenem Nullleiter ist dann nur eine Bypassleitung mit einem hochohmigen Widerstand zwischen dem positiven Pol DC+ und dem negativen Pol DC- auf der Gleichstromseite vorgesehen. Die Auswerteeinrichtung A muss in diesem Fall jedoch an die Anzahl der an eine selbsttätige Netz-Freischalteinrichtung 1 angeschlossenen Wechselrichter 3 angepasst werden, da sich die Spannungsteilereigenschaften der Messschaltung abhängig von dieser Anzahl ändert.

Bei Wechselrichtern 3 ohne durchverbundem Nullleiter ist eine derartige Anpassung nicht erforderlich, da ohnehin wieder zwei Bypassleitungen mit jeweils einem hochohmigen Widerstand vorgesehen sind.

## Patentansprüche

1. Photovoltaikanlage mit wenigstens zwei Wechselrichtern (3), welche über Wechselstromleitungen mittels einer gemeinsamen selbsttätigen Netz-Freischalteinrichtung (1) an ein Stromnetz angeschaltet sind und wobei die selbsttätige Netz-Freischalteinrichtung (1) eine Messschaltung (2) zur Messung der Isolationswiderstände von an die Wechselrichter (3) angeschlossenen Solargeneratoren (5) gegenüber Erde umfasst,
**dadurch gekennzeichnet, dass**
jeder Wechselrichter (3) Bypassleitungen zur Überbrückung der Leistungsteile (4) umfasst und dass in den Bypassleitungen hochohmige Widerstände (R3, R4) angeordnet sind.

2. Photovoltaikanlage nach Anspruch 1, **dadurch gekennzeichnet, dass** bei Wechselrichtern (3) mit durchverbundenem Nullleiter (N) jeder Wechselrichter (3) in der Weise ausgebildet ist, dass eine erste Bypassleitung zwischen dem positiven Pol (DC+) auf der Gleichstromseite und dem Leiter (L) auf der Wechselstromseite angeordnet ist und dass eine zweite Bypassleitung zwischen dem Leiter (L) und dem Nullleiter (N) auf der Wechselstromseite angeordnet ist.

3. Photovoltaikanlage nach Anspruch 1, **dadurch gekennzeichnet, dass** bei Wechselrichtern (3) ohne durchverbundenem Nullleiter (N) jeder Wechselrichter (3) in der Weise ausgebildet ist, dass eine erste Bypassleitung zwischen dem positiven Pol (DC+) auf der Gleichstromseite und dem Leiter (L) auf der Wechselstromseite angeordnet ist und dass eine zweite Bypassleitung zwischen dem negativen Pol (DC-) auf der Gleichstromseite und dem Leiter (L) auf der Wechselstromseite angeordnet ist.

4. Verfahren zum Betreiben einer Photovoltaikanlage nach einem der Ansprüche 1 bis 3, **dadurch gekennzeichnet, dass** vor jeder Anschaltung an das Stromnetz mittels selbsttätiger Netz-Freischalteinrichtung (1) die Messung der Isolationswiderstände beider Pole (R_{DC+}, R_{DC-}) der Solargeneratoren (5) gegenüber Erde bei abgeschalteten Leistungsteilen (4) der Wechselrichter (3) erfolgt.

5. Verfahren nach Anspruch 4, **dadurch gekennzeichnet, dass** die Messung der Isolationswiderstände beider Pole (R_{DC+}, R_{DC-}) der Solargeneratoren (5) gegenüber Erde in der Weise erfolgt, dass die Wechselstromleitungen zwischen den Wechselrichtern (3) und der selbsttätiger Netz-Freischalteinrichtung (1) mit einer Messspannung (U+) beaufschlagt werden und dass ein in den Wechselstromleitungen gemessener Strom- oder Spannungswert in einer Auswerteeinrichtung (A) ausgewertet wird.
